# EUROPEAN PATENT APPLICATION

(11) **EP 1 013 793 A2**
(43) Date of publication of application: **28.06.2000**
(21) Application number: 99125205.7
(22) Date of filing: 17.12.1999
(51) Int. Cl.: C23C 14/35, C23C 14/54, C23C 14/08

(54) **Process and apparatus for material deposition**

(30) Priority: 19.12.1998 GB 9827962
(71) Applicant: APPLIED VISION LTD, Whitwick, Leicestershire LE67 4JP (GB)
(72) Inventor: Walls, John Michael, Crow Borough, East Sussex, TN6 1OW (GB); Jafer, Husein Abidjwad, Loughborough, Leicestershire, LG11 4NJ (GB); Spencer, Alaric Graham, Whitwick, Leicestershire, LE67 4JP (GB); White, Norman Henry, Whitwick, Leicestershire, LE67 4JP (GB); Waugh, Allen Robert, Whitwick, Leicestershire, LE67 4JP (GB)
(74) Representative: Wood, Graham

(57) **Abstract**

The invention to which this application relates is to the deposition of material onto a substrate or substrates to form a coating thereon. The coating can comprise a single material or can be formed from layers of a series of materials to form a multi-layered coating on said substrate. There is provided a method and apparatus for applying a coating onto at least one substrate in a vacuum chamber by the deposition of material from a material deposition means in the chamber onto the substrate, said coating comprising at least one layer of a material and the method and apparatus allows the alteration of the structure of the said coating by altering the application conditions during the application of the coating so as to control the characteristics of the coating to suit specific requirements. This is in contrast to conventional techniques where the application conditions are set at the start of the application of the coating process and remain unaltered during the application of the material or materials to form the coating.

## Description

The invention to which this application relates is to the deposition of material onto a substrate or substrates to form a coating thereon. The coating can comprise a single material or can be formed from layers of a series of materials to form a multi-layered coating on said substrate.

The coatings can be deposited using deposition techniques such as sputter deposition and associated apparatus which can be used to apply coatings onto substrates such as an optical lens to form a relatively thin coating thereon to provide required features such as, for example, anti-reflective qualities. Some examples of materials which can be applied are any of Zirconium, Titanium, Tantalum, Niobium, Tin and equivalent materials, which materials can be deposited using deposition apparatus in which the substrates are held in a vacuum chamber and into which a gas or gases are introduced during the application of the material to control the conditions of application and react with the deposited material. The Applicant has several co-pending applications which describe apparatus of various embodiments of this type.

When depositing material to form a coating on a substrate, there are several conditions which need to be taken into account in order for the coating to have the required characteristics. One characteristic is the adhesion of the coating to the substrate, another is the durability of the coating and, especially with optical lens, another characteristic is the refractive index of the coating. In this invention, the characteristics of durability and refractive index are considered. At the present time, the application of coatings takes place, with for single material coating a uniform gas pressure and flow rate for the duration of the application and, for multi-layered coatings, for all the layers of the same material applied at a uniform gas pressure and flow within the chamber. Thus if, for example, a coating comprises a first layer of Zirconium oxide, a second layer of silicon oxide, a third layer of Zirconium oxide and a fourth layer of silicon oxide, then the first and third layers of Zirconium oxide will be applied with the same gas pressure and flow and the second and fourth layers of silicon will be applied with the same gas pressure and flow. While in some conditions this is acceptable problems are encountered in trying to balance and obtain a coating which has both an acceptable durability and acceptable refractive index as, it is found that due to the way in which the crystalline structure of the layers build, if the durability increases, then the refractive index quality reduces and vice versa.

The aim of the present invention is therefore to provide a method for forming a coating which may be of one material or a number of layers of different materials on a substrate and to improve the features and control of the characteristics of the coating and the multi layers of the coating.

In a first aspect of the invention there is provided a method for applying a coating onto a substrate in a vacuum chamber by the deposition of material from a material deposition means in the chamber onto the substrate, said coating comprising at least one layer of a material and characterised in that the method allows the alteration of the structure of the said coating by altering the application conditions during the application of the coating so as to control the characteristics of the coating to suit specific requirements.

In one embodiment, the material is deposited onto the substrates in the presence of gas introduced into the vacuum chamber and wherein the conditions are altered by controlling the gas pressure and/or flow in the chamber. In one example the material is deposited from a magnetron mounted within the vacuum chamber and in the vicinity of which argon gas is present and the gas pressure and/or flow of the argon gas is controlled to control the structure of the material layer formed.

In a further embodiment the vacuum chamber is provided with a reaction zone in which the deposited material is reacted in the presence of a second gas and wherein the structure of the material layer is controlled by controlling the gas pressure and/or flow of said second gas.

Typically the gas is controlled by altering the speed at which the gas is pumped into the vacuum chamber.

By allowing the control of the structure of the material layer of the coating so specific requirements of the coating can be altered such as any, or any combination of durability of the coating and/or the optical characteristics of the coating.

In one embodiment of the invention the application conditions are altered during the application of one type of material. Furthermore or alternatively if the coating comprises layers of different materials and the application conditions are altered between layers of material. In one embodiment the coating can comprise a number of layers and includes at least two spaced layers of one material and the application conditions for the said two spaced layers are controlled to differ with respect to the application conditions layers of the other material of the coating.

Yet further the method can comprise setting operating conditions for the application of a first layer of a material and then altering and changing the operating conditions for the application of a second layer of the same material in the multi-layered coating.

In a preferred embodiment when forming a multilayered coating the method further includes the analysis of the materials to be applied to form the multi-layered coating prior to the application of the same and the identification of one or other of the materials in said coating which provides the greatest control of the characteristics of the multi-layered coating as a whole.

In one particular embodiment the coating is formed from a series of layers of silicon oxide and zirconium oxide and the application conditions for the application of the zirconium oxide material layers are altered during the formation of the coating. The multi-layered coating can be applied to an optical lens substrate and the preferred microstructure of the zirconium oxide material is formed to have a columnar crystalline structure by increasing the gas pressure during the application of the zirconium oxide material with respect to the gas pressure during the application of the other materials. Yet further the gas pressure during the application of the layers of zirconium oxide can be altered with respect to different layers of the material.

In a further aspect of the invention there is provided apparatus for applying a coating of material to at least one substrate, said apparatus comprising a vacuum chamber in which there is mounted a holder on which the at least one substrate is mounted, a material deposition magnetron, which, when activated, deposits material onto the substrate to form the coating, a means for introducing a gas into the vacuum chamber in the vicinity of the said magnetron and wherein the apparatus further comprises a control system which allows the pressure and/or flow of the said gas to be altered during the application of the material onto the substrate to alter the structure of the coating as it is formed.

In one embodiment the vacuum chamber includes a second magnetron for the application of a second material and the gas pressure and/or flow is controlled to allow the alteration in the structure of adjacent layers of the material and/or spaced layers of the same material. In a further embodiment there is provided a reaction zone in the vacuum chamber into which a second gas is introduced and which causes the reaction of the material of the coating as the substrate is passed through the said reaction zone. Typically a plurality of substrates are coated at the same time in said apparatus and the gas is introduced into the vacuum chamber by pumping apparatus.

Thus the apparatus and method can in one embodiment be used to set operating conditions for the application of a first layer of a material and then altering and changing the conditions for the application of a second layer of the material in a multi-layered coating. In a further feature of the invention the method includes the analysis of the materials to be applied to form the multi-layered coating, prior to the application of the same, and the identification of one or other of the materials in said coating which will provide the greatest control of the characteristics of the coating as a whole.

In one embodiment, the flow of gas and/or the gas pressure into the coating chamber during the application of said material is/are changed between the application of the respective layers of the material to provide the required control of the formation of the respective layers to provide the required characteristics of the multi-layered coating. Alternatively, the gas flow and/or pressure can be altered during the application of a single layer of the material so as to alter the formation of said layer during the application of same. This allows the adjustment and alteration of the format of respective layers of the material in the multi-layered coating and also allows adjustment of the crystalline structure formation within the single layer.

In the formation of the multi-layered coating on an optical lens substrate, the preferred micro-structure of the Zirconium oxide layer is for the same to have a columnar crystalline structure and it has been found that to achieve this, the gas pressure can be increased with respect to the gas pressures during the application of other materials. Yet further, it has been found to alter the pressure of gas between the application of layers of Zirconium oxide so that in one embodiment, a layer of Zirconium oxide which is thinner than another Zirconium oxide layer formed as part of the multi-layered coating, will be applied at a higher pressure of gas than the thicker layer. Thus it will be appreciated that this adjustment of gas pressure in this instance can provide two layers of Zirconium oxide in a multi-layered coating, which layers are of different thickness, and which can be formed and controlled with different gas pressure and /or flow rates so that both have controlled and desired, in this case, refractive index values and durability. It should however be appreciated that the alteration of the gas flow or gas pressure or other operating conditions can be produced to control any of the features of porosity, stress, hardness, refractive index, bulk electrical resistance, absorption, Young's modulus or any other characteristic values of a multi-layered coating which is to be applied and to suit specific requirements.

Furthermore, different requirements for multi-layered coatings for optical lens can be produced with regard to different lens types and in one embodiment, a layer of Si0₂ may be first applied to the substrate surface to form a uniform base upon which the multi-layered coating can then be applied.

Specific examples of the invention are now described with reference to the accompanying diagrams, wherein:-
Figure 1 illustrates one type of multi-layered coating which comprises Zirconium oxide and silicon oxide.
Figure 2 illustrates in plan, one form of apparatus which can be used in accordance with the invention

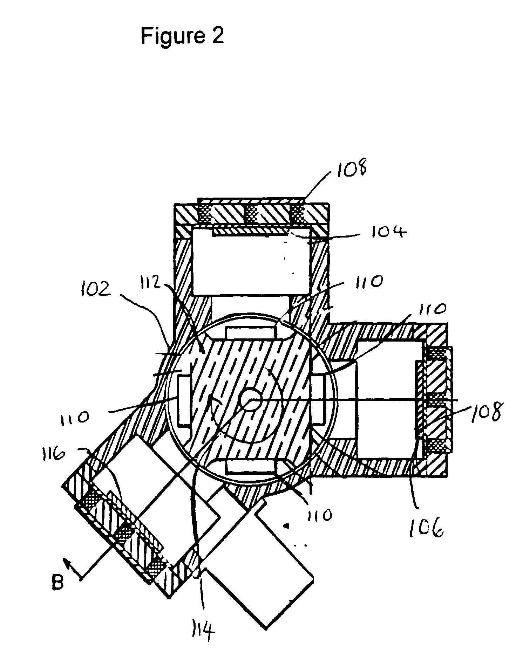

Apparatus for depositing material onto substrates such as optical lens is relatively well known and one example is shown in Figure 2 and can comprise a vacuum chamber 102 in which there is provided first and second magnetrons 104, 106 which each have a target 108 of a particular material. Gas can be pumped into the vacuum chamber and, when the magnetrons are operated in a gas, such as argon, in the vicinity thereof, the magnetrons sputter deposit the target material onto substrates 110 held on a holder 112 to form a coating on the same. The holder can in one embodiment be provided to rotate as indicated by arrow 114 the substrates past the magnetrons in the chamber. By operating the magnetrons at different times, or only one magnetron, so multilayered coatings of the two target materials can be formed or single material coatings can be formed. Typically, a reaction zone 116 is also defined within the vacuum chamber which is created by introducing another gas, such as oxygen, into that area and the material which has been deposited is reacted to form oxides or other chemical compounds depending on the gas present. The control of the gas at the area of material deposition and/or reaction can effect and alter the structure of the material coating and/or layers and the present invention utilises the control of this in a previously unknown way in order to more specifically and advantageously control the formation of a coating as is referred to in the following examples.

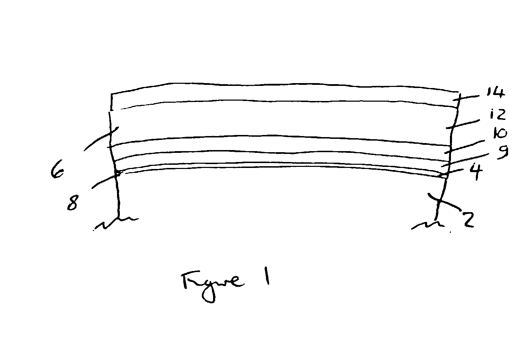

Referring to figure 1 there is illustrated in schematic fashion a substrate 2 with a surface 4 to which is to be applied a multi-layered coating 6 which is shown in increased size for the sake of illustration. The substrate in this embodiment is an optical lens and the coating is to provide an anti-reflective characteristic to the lens. The multi-layered coating comprises a first adhesion layer 8 which is applied to the surface of the substrate to improve the adhesion of the subsequently applied coating to the substrate. A layer of Zirconium oxide 9 is applied followed by a layer of silicon oxide 10, a further layer of Zirconium 12 and a further layer of silicon oxide 14. In this particular arrangement of multi-layered coating, the first layer 9 of Zirconium oxide is substantially thinner than the second layer 12 of Zirconium oxide and equally the first layer 10 of silicon oxide is thinner than the further layer 14 of silicon oxide. In the application of this coating it is identified that the control of the Zirconium oxide layers characteristics has the greater over all impact on the characteristics of the coating. Thus, the aim of the construction of the coating during the application of the materials is to form the layers of Zirconium oxide 9, 12 with the required microstructure as the control of the Zirconium oxide layer construction is found to allow control of the overall durability and refractive index characteristics of the multi-layered coating as a whole. Thus, the silicon oxide layers are applied onto the substrate in substantially uniform gas flow and pressure conditions whereas the first layer of Zirconium oxide is applied at a gas pressure of 36 bar whereas the further layer of Zirconium oxide 12 is applied with a gas pressure of 30 bar as it is expected that this will allow construction of the respective layers 8, 12 to have a refractive index of approximately equal values in the range of 2.1 even though the layers 9,12 are of different thickness and hence allow improvements to the optical characteristics and durability of the multi-layered coating.

The ability to control the construction of each of the layers independently in a multi-layered coating has never previously, to the Applicant's knowledge, been applied to the formation of multi-layered coatings and especially for optical lenses. However, the control of the construction of each layer independently is found to allow significant improvements to the overall multi-layered coating characteristics.

The following example illustrates the invention in practise and the advantages which can be obtained.

Conventionally, in generating a six layer coating the following stages of application were followed with the plastic lens as the base:

| | |
|---|---|
| Air | |
| Si02 | |
| Zr02 | a |
| Si02 | |
| Zr02 | b |
| Si02 | |
| Zr02 | c |
| Plastic lens | |

Given that the argon flows during Zr02 deposition (in order a/b/c and in units of sccm)

Flows of 36/36/36 are used to give a coated lens at stages which has an optical reflection of

| Wavelength (nm) | Reflection (% uncoated) |
|---|---|
| 400 | 70 |
| 444 | 8.7 |
| 525 | 28 |
| 652 | 10.7 |
| 700 | 17 |

and this is the conventional result

By running the process again using the invention with gas flows of 30/33/36 for respective layers of ZrO2 in the order a/b/c respectively then an improved reflection result is obtained.

| Wavelength (nm) | Reflection (% uncoated) |
|---|---|
| 400 | 70 |
| 446 | 7.2 |
| 524 | 21.9 |
| 633 | 8.8 |
| 700 | 20 |

This is a significantly better reflection than obtained with the standard gas flows of 24/24/24 where the peak reflection height is around 25% of uncoated.

In a further example of the invention the formation of a layer of material can be controlled during the formation of the layer by altering and controlling the gas flow and /or pressure in the chamber during the application of said layer. The control can be performed during the application of all or selected layers in a multi layer coating or, alternatively, if a single material coating is applied to the substrate, then the formation and structure of the coating has a whole by altering and controlling the gas flows and pressures in a similar manner as that described in the previous examples but, in this example, during the application of the single material.

## Claims

1. A method for applying a coating onto a substrate in a vacuum chamber by the deposition of material from a material deposition means in the chamber onto the substrate, said coating comprising at least one layer of a material and characterised in that the method allows the alteration of the structure of the said coating by altering the application conditions during the application of the coating so as to control the characteristics of the coating to suit specific requirements.

2. A method according to claim 1 characterised in that the material is deposited onto the substrates in the presence of gas introduced into the vacuum chamber and wherein the conditions are altered by controlling the gas pressure and/ or flow in the chamber.

3. A method according to claim 2 characterised in that the material is deposited from a magnetron mounted within the vacuum chamber and in the vicinity of which argon gas is present and the gas pressure and/or flow of the argon gas is controlled to control the structure of the material layer formed.

4. A method according to claim 3 characterised in that the vacuum chamber is provided with a reaction zone in which the deposited material is reacted in the presence of a second gas and wherein the structure of the material layer is controlled by controlling the gas pressure and/or flow of said second gas.

5. A method according to claim 2 characterised in that the gas control exerted is to alter the speed at which the gas is pumped into the vacuum chamber.

6. A method according to Claim 1 characterised in that the specific requirements of the coating which can be altered by controlling the application conditions can be any, or any combination of durability of the coating and/or the optical characteristics of the coating.

7. A method according to claim 1 characterised in that the application conditions are altered during the application of one type of material.

8. A method according to claim 1 characterised in that the coating comprises layers of different materials and the application conditions are altered between layers of material.

9. A method according to claim 8 characterised in that the coating comprises a number of layers and includes at least two spaced layers of one material and the application conditions for the said two spaced layers are controlled to differ with respect to the application conditions layers of the other material of the coating.

10. A method according to Claim 8 characterised in that the method comprises setting operating conditions for the application of a first layer of a material and then altering and changing the operating conditions for the application of a second layer of the same material in the multi-layered coating.

11. A method according to Claim 10 characterised in that the method further includes the analysis of the materials to be applied to form the multi-layered coating prior to the application of the same and the identification of one or other of the materials in said coating which provides the greatest control of the characteristics of the multi-layered coating as a whole.

12. A method according to Claim 1 characterised in that the coating is formed from a series of layers of silicon oxide and zirconium oxide and the application conditions for the application of the zirconium oxide material layers are altered during the formation of the coating.

13. A method according to Claim 12 characterised in that the multi-layered coating is applied to an optical lens substrate and the preferred microstructure of the zirconium oxide material is formed to have a columnar crystalline structure by increasing the gas pressure during the application of the zirconium oxide material with respect to the gas pressure during the application of the other materials.

14. A method according to Claim 13 characterised in that the gas pressure during the application of the layers of zirconium oxide is altered with respect to different layers.

15. Apparatus for applying a coating of material to at least one substrate, said apparatus comprising a vacuum chamber in which there is mounted a holder on which the at least one substrate is mounted, a material deposition magnetron, which, when activated, deposits material onto the substrate to form the coating, a means for introducing a gas into the vacuum chamber in the vicinity of the said magnetron and characterised in that the apparatus further comprises a control system which allows the pressure and/or flow of the said gas to be altered during the application of the material onto the substrate to alter the structure of the coating as it is formed.

16. Apparatus according to claim 15 characterised in that the vacuum chamber includes a second magnetron for the application of a second material and the gas pressure and/or flow is controlled to allow the alteration in the structure of adjacent layers of the material and/or spaced layers of the same material.

17. A apparatus according to claim 15 characterised in that there is provided a reaction zone in the vacuum chamber into which a second gas is introduced and which causes the reaction of the material of the coating as the substrate is passed through the said reaction zone.

18. Apparatus according to claim 15 characterised in that a plurality of substrates are coated at the same time in said apparatus and the gas is introduced into the vacuum chamber by pumping apparatus.
